# EUROPÄISCHE PATENTSCHRIFT

(11) **EP 0 446 836 B1**
(45) Veröffentlichungstag und Bekanntmachung des Hinweises auf die Patenterteilung: **15.06.1994**
(21) Anmeldenummer: 91103690.3
(22) Anmeldetag: 11.03.1991
(51) Int. Cl.: H05K 7/20, H01L 23/40

(54) **Stromrichtermodul**
Current rectifier module
Module de redresseur de courant

(30) Priorität: 16.03.1990 DE 4008425
(43) Veröffentlichungstag der Anmeldung: 18.09.1991
(73) Patentinhaber: Asea Brown Boveri Aktiengesellschaft, 68309 Mannheim (DE)
(72) Erfinder: Krämer, Wilhelm, W-6902 Sandhausen (DE)
(74) Vertreter: Rupprecht, Klaus, Dipl.-Ing.

(56) Entgegenhaltungen:
- EP-A- 0 274 292
- DE-A- 3 529 911
- US-A- 4 558 395
- US-A- 4 712 388

## Beschreibung

Die Erfindung bezieht sich auf ein Stromrichtermodul gemäß dem Oberbegriff des Anspruchs 1 und wird insbesondere bei Drehstrom-Stromrichtern für Schienenfahrzeuge eingesetzt.

Ein derartiges Stromrichtermodul ist aus den Brown Boveri Mitteilungen 12-73, Seiten 551 bis 558 bekannt. Beim dort beschriebenen ölgekühlten Traktions-Stromrichter eines Schienenfahrzeuges sind der Spannverband mit der Leistungselektronik und die direkten Beschaltungselemente einphasig, jedoch ohne Drosseln und Kurzschließvorrichtungen und ohne Steuer- und Regelelektronik in einem allseitig geschlossenen Gehäuse untergebracht. Isolation und Kühlung erfolgen durch Isolieröl. Zur Kühlung ist ein eigener Ölkreislauf mit externer Umwälzpumpe und Rückkühler vorgesehen. Die elektrischen Anschlüsse sind mit Bohrungen zur Verschraubung mit externen Stromschienen versehen. Zur Verschiebung des Stromrichtermoduls kann dieses durch entsprechende Betätigung von Fahrwerkshebeln von der Auflage abgehoben und auf Rollen gestellt werden.

Da bei diesem Stromrichter nicht alle Beschaltungskomponenten in einem gemeinsamen Gehäuse eingebracht sind, ergeben sich zum Teil längere Stromverbindungen und die Gesamtzahl der notwendigen elektrischen Durchführungen wird größer. Im Störungsfall wird das gesamte Stromrichtermodul gegen eine komplette Reserveeinheit ausgetauscht. Mit dieser Methode wird die Behebung eines Störungsfalles erleichtert, da ein Austausch in Überschaubarer Zeit durchführbar ist.

Es hat sich herausgestellt, daß der zum Ein- und Ausbau eines derartigen Stromrichtermoduls erforderliche Montage- und Zeitaufwand noch relativ groß ist. Beim horizontalen Einbau eines solchen Stromrichtermoduls in einem Stromrichterschrank ergeben sich komplizierte elektrische Verschienungen, die den direkten Ausbau erschweren.

Der Erfindung liegt die Aufgabe zugrunde, ein Stromrichtermodul der eingangs genannten Art anzugeben, das in sehr einfacher Weise in einem Stromrichterschrank ein- und ausbaubar ist.

Diese Aufgabe wird in Verbindung mit den Merkmalen des Oberbegriffes erfindungsgemäß durch die im Kennzeichen des Anspruchs 1 angegebenen Merkmale gelöst. Als Kühlflüssigkeit wird dabei vorzugsweise Isolieröl eingesetzt.

Die mit der Erfindung erzielbaren Vorteile bestehen insbesondere darin, daß das angegebene Stromrichtermodul im Störungsfall sehr einfach auswechselbar ist. Die elektrische Kontaktierung erfolgt ohne Werkzeugeinsatz, indem beim Einfahren des Moduls die Modul-Einfahrkontakte selbsttätig in entsprechende Stromschienen-Gegenkontakte des Stromrichterschrankes eingreifen. Genauso einfach geschieht die hydraulische Kupplung über die Schnellverschlußkupplungen, die in entsprechende Kupplungen im Stromrichterschrank einrasten. Durch die fest installierten Laufrollen ist ein einfaches Ein/Ausfahren des Stromrichtermoduls in den/aus dem Stromrichterschrank möglich. Das aus dem Stromrichterschrank ausgefahrene Stromrichtermodul kann beispielsweise vom Gang im Maschinenraum des Schienenfahrzeuges in die Führerkabine gerollt und von dort unter Einsatz eines Hebezeuges aus dem Fahrzeut transportiert werden. Bei Einsatz der vorgeschlagenen Stromrichtermodule für den Aufbau eines Stromrichters kann ein kostengünstiger Stromrichter mit im Vergleich zur konventionellen Technik deutlich reduziertem Bauvolumen hergestellt werden. Weitere Vorteile sind der nachstehenden Beschreibung entnehmbar.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert.

Es zeigen:
- Fig. 1, 2, 3: eine Frontansicht, eine Seitenansicht und eine Aufsicht eines Stromrichtermoduls gemäß einer ersten Variante,
- Fig. 4, 5, 6: eine Frontansicht, eine Seitenansicht und eine Aufsicht eines Stromrichtermoduls gemäß einer zweiten Variante,
- Fig. 7: eine zur Kontaktierung eines Modul-Einfahrkontaktes geeignete Stromschienen-Einfahrvorrichtung,
- Fig. 8: eine Schnellverschlußkupplung,
- Fig. 9, 10: den internen Ölkreislauf am Beispiel des Stromrichtermoduls gemäß zweiter Variante.

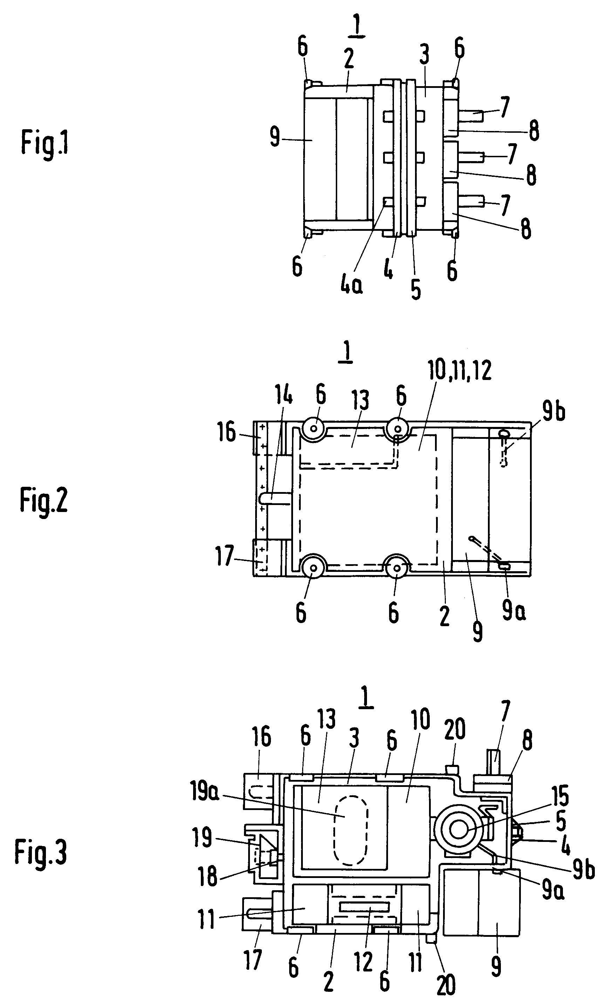

In Fig. 1 ist eine Frontansicht eines Stromrichtermoduls gemäß einer ersten Variante dargestellt. Das Stromrichtermoduls 1 gemäß dieser ersten Variante kann z.B. ein Phasenbaustein eines dreiphasigen Wechselrichters oder ein Gleichrichterbaustein eines Gleichrichters sein. Das Stromrichtermodul 1 besteht aus zwei metallenen Gehäusehälften 2, 3, und ist über Gehäuseflansche 4, 5 mittels Verschraubungen 4a gas- und flüssigkeitsdicht zu einem vollgekapselten, allseitig geschlossenen Gehäuse verbunden. Sowohl an der Oberseite, als auch an der Unterseite des Gehäuses sind jeweils zwei (ggf. drei) Laufrollen 6 an den Außenkanten angeordnet, so daß sich insgesamt acht (ggf. zwölf) Laufrollen ergeben. Die rechte Seitenwand des Stromrichtermoduls 1 wird von den Durchführungsbolzen der drei vertikal angeordneten Modul-Einfahrkontakte 7 durchbrochen. Diese zur Seite gerichteten Modul-Einfahrkontakte 7 dienen zur elektrischen Kontaktierung mit entsprechenden, an Stromschienen eines Stromrichterschrankes befestigten Stromschienen-Einfahrvorrichtungen. Die aus einem elektrisch leitfähigen Material, z.B. Kupfer, bestehenden Einfahrkontakte 7 bilden dabei gleichzeitig die Durchführungsbolzen von ringförmigen Durchführungen oder Meßwandlern 8. Als Meßwandler 8 werden Toroidwandler zur Erfassung der Stromanstiegsgeschwindigkeit des Gleichstroms sowie für die Wechselstrommessung nach dem Hall-Prinzip arbeitende Wandler eingesetzt.

Allgemein gilt für die beiden Gehäusehälften des Stromrichtermoduls, daß die mit den Durchführungen versehene Gehäusehälfte gleichzeitig als Tragteil für alle Einbaukomponenten des Moduls herangezogen wird, während die weitere Gehäusehälfte lediglich eine "Deckelfunktion" hat. Desweiteren gilt allgemein, daß der Toroidwandler selbst die Durchführungsfunktion beinhaltet (Durchführungsbolzen ist gleichzeitig "Primärwicklung" des Toroidwandlers), während beim nach dem Hall-Prinzip arbeitenden Wandler der eigentliche Meßwandlersensor extern auf den Durchführungsbolzen aufgesteckt wird.

In Fig. 1 sind ferner zwei Gate-Unites 9 zu erkennen, die an der Frontseite des Stromrichtermoduls 1 gegenüber den Modul-Einfahrkontakten 7 befestigt und nicht integraler Bestandteil des durch die Gehäusehälften 2, 3 gebildeten vollgekapselten Gehäuses sind.

In Fig. 2 ist eine Seitenansicht eines Stromrichtermoduls gemäß der ersten Variante dargestellt. Im einzelnen ist die Gehäusehälfte 2 mit den an ihrer Ober- und Unterkante befestigten Laufrollen 6 zu erkennen. Die elektrischen Ansteuerleitungen 9b der Gate-Unites 9 gelangen über elektrische Durchführungen 9a mit geeigneten Dichtungen in das Gehäuseinnere des Stromrichtermoduls 1. Im Gehäuseinneren befinden sich außer einem GTO-Spannverband (Gate-Turn-off-Thyristoren, siehe Ziffer 15 in Fig. 3) GTO-Beschaltungskomponenten 10 (z.B. Kondensatoren und Dioden), eine Drossel 11, ein Kurzschließer 12 sowie ein Widerstand 13. Bedarfsweise können weitere Komponenten, wie z.B. integrale Befestigungschassis für die Bauelemente, im Gehäuseinneren angeordnet sein. Sämtliche Komponenten sind vorzugsweise jeweils über Befestigungspunkte unter Zwischenschaltung eines Chassis im Inneren der Gehäusehälfte 2 befestigt und nach Demontage der Gehäusehälfte 3 zugänglich.

Um ein exaktes Einschieben des Stromrichtermoduls 1 in einen Stromrichterschrank zu gewährleisten, ist die Rückseite des Gehäuses mit einem Führungszapfen 14 (Zentrierstift) versehen, der in eine entsprechende Führungsöffnung an der Rückenplatte des Schrankes eingreift. Wahlweise kann auch umgekehrt hierzu eine Führungsöffnung an der Rückseite des Gehäuses angeordnet sein, in die ein an der Rückenplatte des Stromrichterschranks befestigter Führungszapfen eingreift. Auch andere Zentriereinrichtungen wie Fugenleisten sind einsetzbar.

Wie bereits eingangs erwähnt, ist das Stromrichtermodul 1 ölgekühlt, d.h. die während des Betriebes entstehende Verlustleistungswärme wird über einen Ölkreislauf mit Umwälzpumpe aus dem Modul und dem Stromrichterschrank transportiert und mittels eines externen Rückkühlers an die Außenluft abgeführt. zum Transport des rückgekühlten Öls in das Modul und des aufgeheizten Öls aus dem Modul sind an der Rückseite des Gehäuses zwei hydraulische Schnellverschlußkupplungen 16, 17 (Zulauf, Rücklauf) vorgesehen. Diese Schnellverschlußkupplungen 16, 17 greifen in entsprechende Kupplungen am rückseitigen Ölrahmen (Ölzufuhr oder -Sammelrohre) des Stromrichterschrankes ein, wobei die Ölführung im Stromrichterschrank bei Phasenbausteinen vorzugsweise über Trag/Ölführungsprofile erfolgt, die sowohl als Traggerüst zum mechanisch robusten Aufbau des Stromrichterschrankes als auch zur Führung des Isolieröls dienen. Die beiden Schnellverschlußkupplungen 16, 17 befinden sich vorzugsweise an diagonal entgegengesetzten Ecken der Rückseite des Modulgehäuses.

In Fig. 3 ist eine Aufsicht auf ein Stromrichtermodul gemäß der ersten Variante dargestellt. Im einzelnen sind die beiden Gehäusehälften 2, 3 des Stromrichtermoduls 1, die beiden Gehäuseflansche 4, 5, ein Teil der bis zu zwölf Laufrollen 6, ein Modul-Einfahrkontakt 7 mit Durchführung/Meßwandler 8 und die beiden Gate-Unites 9 zu erkennen. Im Gehäuseinneren befinden sich die GTO-Beschaltung 10, die Drossel 11, der Kurzschließer 12, der Widerstand 13 und der GTO-Spannverband 15, beispielsweise bestehend aus zwei GTO-Thyristoren und zwei Dioden.

Während die elektrischen Leistungsanschlüsse der GTO-Thyristoren mit den entsprechenden Modul-Einfahrkontakten 7 verbunden sind, führen die Ansteuerleitungen 9b der einzelnen GTO-Thyristoren getrennt hiervon über abgedichtete elektrische Durchführungen 9a zu den Gate-Unites 9.

An der Rückseite des Moduls 1 sind die beiden Schnellverschlußkupplungen 16, 17 sowie ein Überströmventil 18 zu erkennen, das oberhalb eines vorgebbaren, eingestellten Öldrucks Isolieröl aus dem Gehäuseinneren des Moduls 1 in einen an der Rückseite des Gehäuses befindlichen Ölauffangraum 19 leitet. Diese aus Überströmventil 18/Ölauffangraum 19 bestehende Sicherheitsvorrichtung ist notwendig, um eine bei einem vom externen Ölkreislauf abgekuppelten Stromrichtermodul auftretende Öldruckerhöhung auf ungefährliche Werte zu begrenzen. Die nach dem Abkuppeln des Stromrichtermoduls auftretende Öldruckerhöhung wird z.B. durch die in den elektrischen Bauteilen des Moduls vorhandene, zeitverzögert an das Isolieröl abgeführte Restwärme verursacht. Möglich ist auch eine Temperaturerhöhung des Moduls nach dem Ausbau infolge Wärmezufluß von außen.

Mit Ziffer 20 sind Modulbefestigungen bezeichnet, die zur Arretierung und Befestigung des Stromrichtermoduls am Stromrichterschrank dienen. Mittels an den Modulbefestigungen 20 angreifender geeigneter Schraubmechanismen können erhöhte Ein- und Ausfahrkräfte erzielt werden. Die Modulbefestigungen 20 sind vorzugsweise derart angeordnet, daß sich eine zusätzliche mechanische Stabilisierung des Stromrichterschranks ergibt, wenn sich die Stromrichtermodule in der Betriebsstellung befinden.

Anstelle der Sicherheitsvorrichtung Überströmventil 18/Ölauffangraum 19 kann auch ein innerhalb des Gehäuses angeordneter Blasenspeicher verwendet werden. Dieser in Fig. 3 gestrichelt dargestellte, alternativ einsetzbare Blasenspeicher 19a ist mit Gas gefüllt (z.B. mit Luft) und wird bei erhöhtem Öldruck innerhalb des Gehäuses entsprechend komprimiert, wodurch ein Druckausgleich und eine Herabsetzung des Öldrucks auf ungefährliche Werte bewirkt wird.

Wie bereits aus der vorstehenden Beschreibung des Stromrichtermoduls gemäß Fig. 1 bis 3 hervorgeht, ist das Stromrichtermodul 1 so konzipiert, daß es in sehr einfacher Weise in einen Stromrichterschrank eingeschoben und bedarfsweise (z.B. bei einem Defekt des Moduls) wieder aus dem Stromrichterschrank ausgefahren werden kann. Die Führung der Laufrollen 6 während des Ein- bzw. Ausschiebens übernehmen geeignet ausgebildete Profile innerhalb des Schrankes. Nach erfolgtem Einschub ist über die Schnellverschlußkupplungen 16, 17 eine Verbindung des innerhalb des Gehäuses befindlichen Isolieröls mit einem externen Ölkreislauf selbsttätig gegeben, wobei der Ölumlauf durch eine externe Umwälzpumpe forciert wird. Gleichzeitig ist nach erfolgtem Einschub die elektrische Leistungsverbindung über die Modul-Einfahrkontakte 7 und die entsprechenden Stromschienen-Einfahrvorrichtungen mit den Stromschienen des Stromrichterschrankes automatisch gegeben. Es sind lediglich noch die Elektronikanschlüsse der Gate-Unites 9 mittels Steckverbindern zu kontaktieren.

Wird das Stromrichtermodul lediglich geringfügig aus dem Stromrichterschrank herausgeschoben, jedoch nicht entfernt, so werden automatisch die elektrischen Leistungsverbindungen über die Modul-Einfahrkontakte 7 getrennt und die Schnellverschlußkupplungen 16, 17 schließen das Gehäuseinnere des Moduls gas- und flüssigkeitsdicht ab. Auf diese Weise sind zusätzliche Trennschalter zur Abkopplung des Stromrichters vom speisenden Netz oder des Generators bei diesel-elektrischen Lokomotiven nicht erforderlich.

Das Stromrichtermodul 1 kann auch um 180° gedreht in einen Stromrichterschrank eingeschoben werden, da die Laufrollen 6 sowohl an den Oberkanten als auch an den Unterkanten der beiden Seitenwände des Gehäuses angeordnet sind. Nach Drehung um 180° weisen die Modul-Einfahrkontakte 7 nicht mehr nach rechts, wie in Fig. 1 dargestellt, sondern nach links. Infolge der universellen Einbaufähigkeit der Stromrichtermodule kann beispielsweise ein Stromrichterschrank aufgebaut werden, der zwei Modulreihen - jeweils bestehend aus drei oder mehr vertikal gestapelten Stromrichtermodulen - aufweist, wobei die Einfahrkontakte 7 der Module beider Reihen jeweils zu den zentral zwischen beiden Reihen angeordneten Stützkondensatoren und Stromschienen weisen. Für beide Reihen kann vorteilhaft das gleiche Stromrichtermodul verwendet werden, was bei der Herstellung, Lagerhaltung und beim Austausch im Störungsfall von großem Vorteil ist.

Allgemein gilt, daß die Halbleiter (GTO, Dioden) des Stromrichtermoduls in Form eines Spannverbandes eine vertikale Aufbaustruktur haben und mit der einen Seite räumlich der an der Frontseite des Stromrichterschranks angeordneten externen Verschienung bzw. den Stützkondensatoren und mit der anderen Seite den ebenfalls frontseitig liegenden elektronischen Ansteuermitteln zugewandt sind, während die GTO-nahen Beschaltungselemente und Drosseln in Richtung zur Schrankrückwand (die Schranktiefe ausfüllend) angeordnet sind.

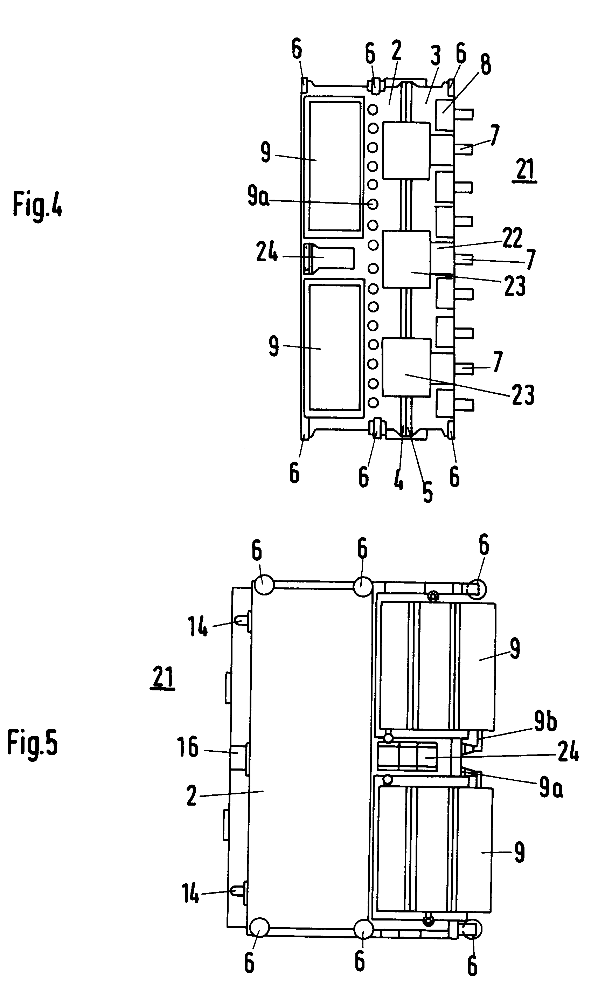

In Fig. 4 ist eine Frontansicht eines Stromrichtermoduls gemäß einer zweiten Variante dargestellt. Das Stromrichtermodul 21 gemäß der zweiten Variante kann z.B. ein kompletter dreiphasiger Wechselrichter oder ein kompletter Gleichrichter sein, wobei die Komponenten, wie Thyristoren und Beschaltungen, jeweils vertikal innerhalb des Stromrichtermoduls gestapelt sind. Infolge der vertikalen Aufbaustruktur innerhalb des Moduls ergibt sich vorteilhaft eine Minimierung der erforderlichen Kreuzungen der elektrischen Verbindungen. Es sind wiederum die beiden Gehäusehälften 2, 3 mit Gehäuseflanschen 4, 5 zu erkennen. Bedingt durch das relativ hohe Gewicht dieses Stromrichtermoduls 21 sind für den Ein- und Ausschub des Moduls insgesamt zwölf oder achtzehn Laufrollen 6 vorgesehen, die in je drei Reihen zu je drei Laufrollen an den Ober- und Unterseiten des Moduls verteilt sind. Die Modul-Einfahrkontakte 7 mit Durchführungen/Meßwandlern 8 bzw. Stromwandlern 22 sind vertikal angeordnet. Die hierzu getrennten Ansteuerleitungen der bis zu sechs Gate-Unites 9 gelangen über elektrische Durchführungen 9a in das Gehäuseinnere. Mit Ziffer 23 sind Auswerteelektroniken für die Stromwandler 22 und mit Ziffer 24 sind Zündgeräte für die Kurzschließer 12 im Stromrichtermodul bezeichnet.

In Fig. 5 ist eine Seitenansicht eines Stromrichtermoduls gemäß der zweiten Variante dargestellt. Es ist die Gehäusehälfte 2 des Stromrichtermoduls 21 mit sechs Laufrollen 6 zu erkennen. Frontseitig sind die vertikal angeordneten Gate-Unites 9 mit zu den elektrische Durchführungen 9a führenden Ansteuerleitungen 9b angeordnet. Etwa in der Mitte der Rückseite des Modulgehäuses befinden sich die hydraulischen Schnellverschlußkupplungen 16. Alternativ dazu können die Kupplungen auch an der Unterseite bzw. der Oberseite des Moduls angeordnet werden. In diesem Falle werden sie in einem Fahruntersatz untergebracht. Im oberen und im unteren Abschnitt der Gehäuserückseite sind Führungszapfen 14 angeordnet und in entsprechend ausgebildete Führungsöffnungen an der Rückenplatte des zugehörigen Stromrichterschrankes einführbar.

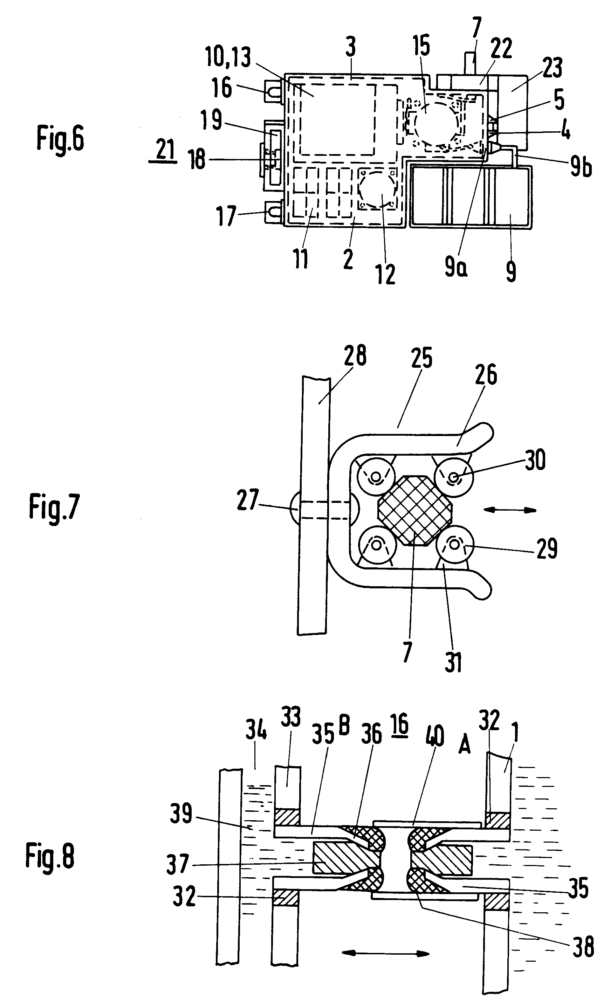

In Fig. 6 ist eine Aufsicht auf ein Stromrichtermodul gemäß einer zweiten Variante dargestellt. Es sind wiederum die beiden Gehäusehälften 2, 3 mit Gehäuseflanschen 4, 5 zu erkennen. Die Modul-Einfahrkontakte 7 sind teilweise gleichzeitig Durchführungsbolzen von Stromwandlern 22 mit zugehörigen, extern an der Frontseite des Gehäuses angeordneten Auswerteelektroniken 23. Gegenüber den Modul-Einfahrkontakten 7 sind wiederum die Gate-Unites 9 angeordent, deren Ansteuerleitungen 9b über elektrische Durchführungen 9a ins Gehäuseinnere gelangen und mit den Steueranschlüssen der Thyristoren des GTO-Spannverbandes 15 verbunden sind. Die weiteren, in Gehäuseinneren des Stromrichtermoduls 21 angeordneten Komponenten, wie Widerstand 13, Drossel 11, Kurzschließer 12 sowie weitere GTO-Beschaltungskomponenten 10 sind angedeutet. An der Rückseite des Gehäuses befinden sich die hydraulischen Schnellverschlußkupplungen 16, 17 sowie das Überströmventil 18 mit Ölauffangraum 19.

In Fig. 7 ist eine zur Kontaktierung eines Modul-Einfahrkontaktes geeignete Stromschienen-Einfahrvorrichtung dargestellt. Die Stromschienen-Einfahrvorrichtung 25 weist einen im Querschnitt U-förmigen Rahmen 26 auf, der über eine Schraubverbindung 27 an der Stromschiene 28 befestigt ist. Im Innern des Rahmens 26 sind vier Rundstäbe mit aufgefädelten Lochscheibenrollen 29 im gleichmäßigen Abstand voneinander angeordnet, die einzeln gefedert viele Einzelkontaktpunkte bilden. Die Achsen 30 der drehbeweglichen Lochscheibenrollen 29 sind über Halterungen 31 mit dem Rahmen 26 verbunden. Beim Einfahren und Ausfahren des im Querschnitt achteckigen Modul-Einfahrkontaktes 7 rollen die Lochscheibenrollen federnd über die Kanten und Flächen des Modul-Einfahrkontaktes ab. Die Ein/Ausfahr-Richtung ist durch Pfeile gekennzeichnet. Im eingefahrenen Zustand drücken die Lochscheibenrrollen 29 gegen die Seitenflächen des Modul-Einfahrkontaktes 7, wodurch wegen der vielen Einzelrollen und der damit gegebenen Vielfachkontaktierung eine hohe Stromübertragungsfähigkeit gewährleistet ist.

In Fig. 8 ist eine Schnellverschlußkupplung dargestellt. Die Schnellverschlußkupplung 16 besteht aus einem Schnellverschlußkupplungsteil A, das über einen Flansch 32 an der durchbrochenen Wandung des Stromrichtermoduls 1 befestigt ist, sowie aus einem Schnellverschlußkupplungsteil B, das über einen Flansch 32 an der durchbrochenen Rahmenwandung 33 des Trag/Ölführungs-Profils 34 befestigt ist. Beide Teile A, B weisen ein mit dem Flansch 32 verbundenes Ventilgehäuse 35 mit abgewinkelter Stirnfläche 36 auf. Im ausgekuppelten Zustand drükken im Innern des Ventilgehäuses 35 befindliche Ventilkegel 37 abdichtend gegen die Innenflächen der Stirnflächen 36. Eine zusätzliche Abdichtung ergibt sich durch Dichtungsmanschetten 38, die über die Außenflächen der Stirnflächen 36 und über die Ventilkegel 37 greifen. Im eingekuppelten Zustand drücken die Stirnflächen der Ventilkegel 37 und die der Dichtungsmanschetten 38 gegeneinander, wodurch sich Ringkanäle jeweils zwischen den Ventilgehäusen 35 bzw. den Dichtungsmanschetten und Ventilkegeln 37 ausbilden, durch die das Isolieröl 39 des Ölkühlkreislaufes fließen kann. Eine Abdichtung nach außen ergibt sich zusätzlich durch einen Mantel 40, der gegen die Dichtungsmanschetten 38 drückt. Die Ein/Auskuppel-Richtung ist durch Pfeile gekennzeichnet. Als Kühlflüssigkeit kann neben dem vorzugsweise verwendeten Isolieröl z.B. auch entionisiertes Wasser eingesetzt werden.

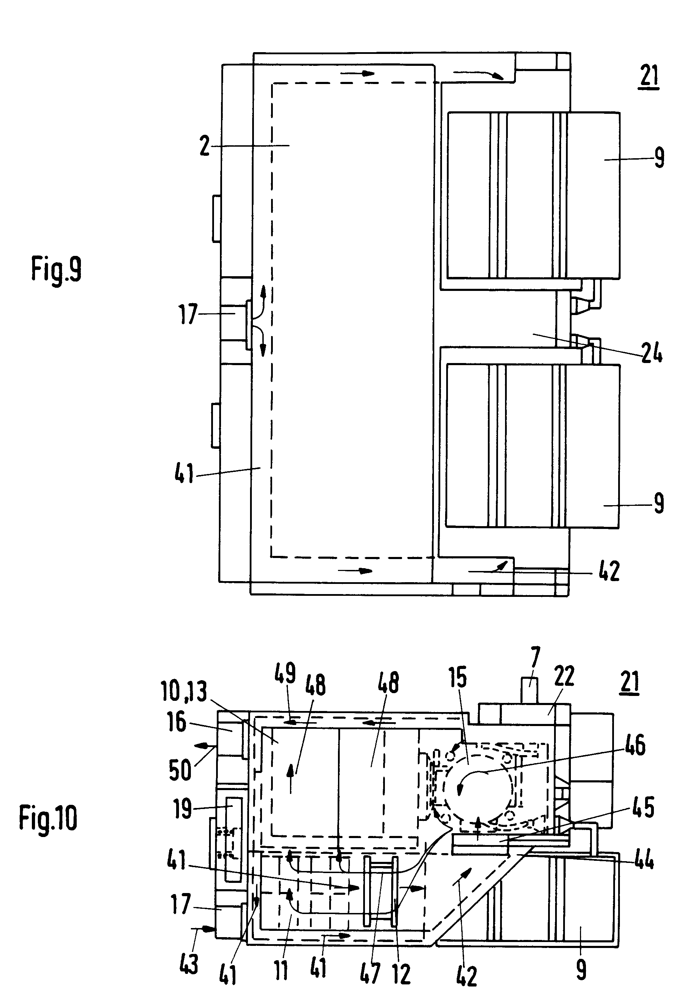

In den Figuren 9 und 10 ist der interne Ölkreislauf am Beispiel des Stromrichtermoduls gemäß zweiter Variante dargestellt. Figur 9 zeigt in einer Seitenansicht des Stromrichtermoduls 21 den mittels einer Doppelwandung innerhalb des Modulgehäuses gebildeten Ölkanal 41, der das über die hydraulische Schnellverschlußkupplung 17 einströmende Isolieröl gleichmäßig nach oben wie nach unten über die Rücken- und Seitenflächen verteilt. Der Ölkanal 41 besitzt Ölkanalausgänge 42 in unmittelbarer Nähe der zu kühlenden Stromrichterventile (GTO-Spannverbände).

Figur 10 zeigt in einer Aufsicht des Stromrichtermoduls 21 den genauen Verlauf des internen Ölkreislaufs. Es ist der Öleintritt 43 über die Schnellverschlußkupplung 17 zu erkennen. Durch den mittels der internen Doppelwandung gebildeten Ölkanal 41 und den Ölkanalausgang 42 gelangt das Isolieröl zu einem Ölverteiler 44 (vorzugsweise Kunststoffprofil). Vom Ölverteiler 44 führen Öleintritte 45 jeweils zu den Stromrichterventil-Kühlkörpern der GTO-Spannverbände 15. Die spiralförmige Ölführung innerhalb der Kühlkörper ist mit GTO-Kühlung 46 bezeichnet. Vom Ausgang der Kühlkörper ergibt sich eine Ölströmung 47 am Kurzschließer 12 und an den Drosseln 11 vorbei, woran sich eine Ölströmung 48 durch die Widerstände 13 und GTO-Beschaltungskomponenten 10 anschließt. Ein Ölansaugraun (vorzugsweise durch Blechchassis geformt) bildet einen Rücklauf 49 zur Schnellverschlußkupplung 16 mit dem Ölaustritt 50 in die Ölverteilerrohre (nicht gezeigt) oder in die Trag/Ölführungs-Profile des Stromrichterschrankes.

Vorzugsweise ist ein Nebenschluß (Bypass) vom Ölverteiler 44 über ein Hohlkühlprofil zu den Halbleiterbauelementen (z.B. Dioden) der GTO-Beschaltungskomponenten 10 vorgesehen, wodurch die Halbleiterbauelemente unterhalb des Spannverbandes vorteilhaft mit noch nicht aufgeheiztem Isolieröl gekühlt werden.

Bei Herstellung der Gehäusehälften 2, 3 des Stromrichtermodulgehäuses in Metallgießtechnik (z.B. Aluminiumguß) kann die den Ölkanal 41 formende Doppelwandung einschließlich der Ölauffangräume 19 in einfacher Weise gebildet werden (Hohlwand).

Wie aus der vorstehenden Erläuterung des internen Ölkreislaufs hervorgeht, werden die temperaturempfindlichen Bauelemente, wie insbesondere die GTO-Thyristoren und Dioden, mit noch nicht aufgeheiztem Isolieröl gekühlt, während die weniger temperaturempfindlichen Bauelemente, wie Drosseln, GTO-nahe Beschaltung und die Widerstände 13, mit bereits aufgeheiztem Isolieröl versorgt werden. Diese Maßnahme ist auch deshalb sinnvoll, da die Widerstände 13 im Normalbetrieb mehr als 50% Anteil an der vom Stromrichtermodul produzierten Verlustwärme haben.

## Patentansprüche

1. Stromrichtermodul mit einem metallischen vollgekapselten, allseitig geschlossenen Gehäuse, in dem Stromrichterventile sowie Beschaltungskomponenten, wie Drosseln, Widerstände und Kondensatoren angeordnet sind, und das zur Kühlung und Isolation mit einer Kühlflüssigkeit gefüllt ist, wobei das Gehäuse mit zwei Anschlüssen für die Zu- und Abführung der Kühlflüssigkeit, sowie mit mehreren Durchführungen für externe elektrische Leistungsanschlüsse versehen ist, dadurch gekennzeichnet, daß für die Zu- und Abfuhr der Kühlflüssigkeit zwei hydraulische Verschlußkupplungen (16,17) an der Rückseite des Gehäuses angeordnet sind, daß an der Frontseite des Gehäuses und zur Seite gerichtet mehrere zur Kontaktierung mit Stromschienen-Einfahrvorrichtungen geeignete elektrische Modul-Einfahrkontakte (7) gruppiert sind, und daß das Gehäuse mit fest installierten Laufrollen (6) versehen ist.

2. Stromrichtermodul nach Anspruch 1, dadurch gekennzeichnet, daß das Gehäuse aus zwei miteinander über Gehäuseflansche (4,5) verschraubbaren Gehäusehälften (2,3) besteht.

3. Stromrichtermodul nach Anspruch 1 und/oder 2, dadurch gekennzeichnet, daß die Durchführungen als Meßwandler, vorzugsweise als Toroidwandler bzw. Hall-Wandler (8) oder Stromwandler (22), ausgebildet sind.

4. Stromrichtermodul nach einem der vorstehenden Ansprüche 1 bis 3, dadurch gekennzeichnet, daß mindestens ein Führungsmittel (14) an der Rückseite des Gehäuses angeordnet ist, das in eine entsprechende Führungsöffnung an der Rückenplatte eines Stromrichterschrankes eingreift.

5. Stromrichtermodul nach einem der vorstehenden Ansprüche 1 bis 3, dadurch gekennzeichnet, daß mindestens eine Führungsöffnung an der Rückseite des Gehäuses angeordnet ist, in die ein entsprechendes Führungsmittel an der Rückenplatte eines Stromrichterschrankes eingreift.

6. Stromrichtermodul nach wenigstens einem der Ansprüche 1 bis 5, dadurch gekennzeichnet, daß ein externer Kühlflüssigkeitsauffangraum (19) am Gehäuse vorgesehen ist, der über ein Überstromventil (18) mit dem Gehäuseinneren verbunden ist.

7. Stromrichtermodul nach wenigstens einem der Ansprüche 1 bis 5, dadurch gekennzeichnet, daß ein gasgefüllter Blasenspeicher (19a) im Gehäuseinneren vorgesehen ist.

8. Stromrichtermodul nach einem der Ansprüche 1 bis 7, dadurch gekennzeichnet, daß mindestens ein Kurzschließer (12) im Gehäuseinnern integriert ist.

9. Stromrichtermodul nach einem der Ansprüche 1 bis 8, dadurch gekennzeichnet, daß Elektronikbaugruppen, insbesondere Gate-Unites (9), an der Frontseite am ausgesparten Gehäuse und gegenüber den elektrischen Anschlüssen befestigt sind, deren Ansteuerleitungen (9b) über abgedichtete elektrische Durchführungen (9a) in das Gehäuseinnere führen.

10. Stromrichtermodul nach einem der Ansprüche 1 bis 9, dadurch gekennzeichnet, daß zur Befestigung des Stromrichtermoduls in einem Stromrichterschrank an der Frontseite des Gehäuses Modulbefestigungen (20) vorgesehen sind.

11. Stromrichtermodul nach wenigstens einem der Ansprüche 1 bis 10, dadurch gekennzeichnet, daß die Laufrollen (6) sowohl an der Oberseite als auch an der Unterseite des Gehäuses angeordnet sind.

12. Stromrichtermodul nach wenigstens einem der Ansprüche 1 bis 10, dadurch gekennzeichnet, daß durch Kühlflüssigkeitskanäle und Kühlflüssigkeitsverteiler ein innerer Kühlflüssigkeitskreislauf erzwungen wird, bei den temperaturempfindliche Bauteile vorzugsweise mit noch nicht erhitzter Kühlflüssigkeit beaufschlagt werden.

13. Stromrichtermodul nach Anspruch 12, dadurch gekennzeichnet, daß die Gehäusewandung des Modulgehäuses zur Bildung eines Kühlflüssigkeitskanales (41) doppelwandig ausgeführt ist.

## Claims

1. Power converter module having a metallic fully encapsulated housing which is enclosed on all sides and in which power converter valves and circuit components such as inductors, resistors and capacitors are arranged, and which is filled with a cooling fluid for cooling and insulation, the housing being provided with two terminals for feeding and conducting away the cooling fluid and with a plurality of bushings for external electrical power connections, characterized in that two hydraulic closure couplings (16, 17) are arranged on the rear side of the housing for feeding and conducting away the cooling fluid, in that a plurality of electrical module insertion contacts (7) which are suitable for making contact with contact rail insertion devices are grouped on the front side of the housing and directed towards the side, and in that the housing is provided with permanently installed running rollers (6).

2. Power converter module according to Claim 1, characterized in that the housing consists of two housing halves (2, 3) which can be screwed to one another via housing flanges (4, 5).

3. Power converter module according to Claim 1 and/or 2, characterized in that the bushings are constructed as measuring transformers, preferably as toroidal transformers or Hall transformers (8) or current transformers (22).

4. Power converter module according to one of the preceding Claims 1 to 3, characterized in that at least one guide means (14) is arranged on the rear side of the housing, which means (14) engages in a corresponding guide opening on the rear panel of a power converter cabinet.

5. Power converter module according to one of the preceding Claims 1 to 3, characterized in that at least one guide opening is arranged on the rear side of the housing, in which opening a corresponding guide means on the rear panel of a power converter cabinet engages.

6. Power converter module according to at least one of Claims 1 to 5, characterized in that an external cooling fluid collecting space (19) is provided on the housing, which space (19) is connected to the interior of the housing via an overflow valve (18).

7. Power converter module according to at least one of Claims 1 to 5, characterized in that a gas-filled bubble accumulator (19a) is provided in the interior of the housing.

8. Power converter module according to one of Claims 1 to 7, characterized in that at least one short-circuit element (12) is integrated in the interior of the housing.

9. Power converter module according to one of Claims 1 to 8, characterized in that electronic assemblies, in particular gate units (9), are attached to the front side on the recessed housing and opposite the electrical terminals whose drive lines (9b) lead via sealed electrical bushings (9a) into the interior of the housing.

10. Power converter module according to one of Claims 1 to 9, characterized in that module attachments (20) are provided on the front side of the housing in order to attach the power converter module in a power converter cabinet.

11. Power converter module according to at least one of Claims 1 to 10, characterized in that the running rollers (6) are arranged both on the upper side and on the lower side of the housing.

12. Power converter module according to at least one of Claims 1 to 10, characterized in that an inner cooling fluid circulation is forcibly brought about by means of cooling fluid channels and cooling fluid distributors, in which circulation temperature-sensitive components are preferably acted on with cooling fluid which has not yet heated up.

13. Power converter module according to Claim 12, characterized in that the housing wall of the module housing is designed to form a cooling fluid channel (41) with double walls.

## Revendications

1. Module convertisseur de courant comportant un boîtier métallique fermé de tous les côtés, entièrement étanche, dans lequel sont disposées des valves convertisseuses ainsi que des composants de circuit, tel que des selfs, des résistances et des condensateurs, et qui, pour le refroidissement et l'isolation est rempli d'un liquide de refroidissement, le boîtier étant pourvu de deux raccords pour l'arrivée et le départ du liquide de refroidissement et de plusieurs traversées pour des connexions électriques extérieures, caractérisé par le fait que deux raccords à obturateur (16, 17) sont disposés sur la face arrière du boîtier, par le fait que plusieurs contacts embrochables (7) électriques adaptés pour réaliser le contact avec des dispositifs de connexion par embrochage sont groupés sur la face avant du boîtier et sont orientés vers le côté et par le fait que le boîtier est pourvu de galets de roulement montés à demeure.

2. Module convertisseur de courant selon la revendication 1, caractérisé par le fait que le boîtier est formé de deux moitiés de boîtier (2, 3) qui sont assemblées par vis par l'intermédiaire de brides d'assemblage (4, 5).

3. Module convertisseur de courant selon la revendication 1 et/ou 2, caractérisé par le fait que les passages sont agencés sous forme de convertisseur de mesure, de préférence sous forme de convertisseur toroïdal ou de convertisseur de Hall (8) ou de convertisseur de courant (22).

4. Module convertisseur de courant selon l'une des revendications 1 à 3 précédentes, caractérisé par le fait qu'il est prévu sur la face arrière du boîtier au moins un moyen de guidage (14) qui s'engage dans une ouverture de guidage adaptée dans le panneau arrière d'une armoire convertisseuse.

5. Module convertisseur de courant selon l'une des revendications 1 à 3 précédentes, caractérisé par le fait qu'il est prévu dans la face arrière du boîtier au moins une ouverture de guidage dans laquelle s'engage un moyen de guidage adapté sur le panneau arrière d'une armoire convertisseuse.

6. Module convertisseur de courant selon au moins une des revendications 1 à 5, caractérisé par le fait qu'il est prévu sur le boîtier une chambre de réception (19) du liquide de refroidissement qui communique avec l'intérieur du boîtier par l'intermédiaire d'une soupape de décharge (18).

7. Module convertisseur de courant selon au moins une des revendications 1 à 5, caractérisé par le fait qu'il est prévu à l'intérieur du boîtier un accumulateur à vessie (19a) qui est rempli de gaz.

8. Module convertisseur de courant selon une des revendications 1 à 7, caractérisé par le fait qu'au moins un court-circuiteur (12) est intégré dans boîtier.

9. Module convertisseur de courant selon une des revendications 1 à 8, caractérisé par le fait que des organes électroniques, en particulier des ensembles gâchettes (9) sont fixés sur la face avant du boîtier présentant des évidements, en regard des connecteurs électriques, dont les lignes de commande (9b) pénètrent à l'intérieur du boîtier par l'intermédiaire de traversées (9a) électriques étanches.

10. Module convertisseur de courant selon une des revendications 1 à 9, caractérisé par le fait que des moyens de fixation (20) sont prévus sur la face avant du boîtier pour la fixation du module convertisseur de courant dans une armoire.

11. Module convertisseur de courant selon au moins une des revendications 1 à 10, caractérisé par le fait que les galets (6) sont disposés aussi bien sur la face supérieure que la face inférieure du boîtier.

12. Module convertisseur de courant selon au moins une des revendications 1 à 10, caractérisé par le fait qu'un circuit de liquide de refroidissement est créé au moyen de canaux et de répartiteurs de liquide, circuit au moyen duquel les composants sensibles à la température sont balayés de préférence par du fluide non encore réchauffé.

13. Module convertisseur de courant selon la revendications 12, caractérisé par le fait que la paroi du boîtier du module est double afin de former un canal (41) pour le liquide de refroidissement.
